(19) Europäisches Patentamt / European Patent Office / Office européen des brevets

(11) **EP 4 766 067 A2**

(12) **EUROPEAN PATENT APPLICATION**

(43) Date of publication:
24.06.2026 Bulletin 2026/26

(21) Application number: 25220708.9

(22) Date of filing: 04.12.2025

(51) International Patent Classification (IPC):
$H10B\ 41/30^{(2023.01)}$    $H10D\ 30/68^{(2025.01)}$
$H10D\ 64/01^{(2025.01)}$

(52) Cooperative Patent Classification (CPC):
H10B 41/30; H10D 30/6891; H10D 64/035

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 19.12.2024 CN 202411887429

(71) Applicants:
• GigaDevice Semiconductor (Shanghai) Inc.
Shanghai 201210 (CN)
• GIGADEVICE SEMICONDUCTOR (HEFEI) INC.
Hefei Anhui 230031 (CN)
• GIGADEVICE SEMICONDUCTOR (XIAN) INC.
Xi'an Shaanxi 710065 (CN)
• GigaDevice Semiconductor Inc.
Haidian, Beijing 100094 (CN)

(72) Inventors:
• XU, Jing
No.505 Zhangjiang Road, Shanghai, 201210 (CN)
• QIAN, Meng
No.505 Zhangjiang Road, Shanghai, 201210 (CN)
• XU, Yisheng
No.505 Zhangjiang Road, Shanghai, 201210 (CN)

(74) Representative: Herrero & Asociados, S.L.
Edificio Aqua - Calle Agustín de Foxá, 4-10, 2ºA
28036 Madrid (ES)

(54) **METHOD FOR MANUFACTURING SEMICONDUCTOR DEVICE, SEMICONDUCTOR DEVICE, AND MEMORY DEVICE**

(57) A method for manufacturing a semiconductor device (10), a semiconductor device (10), and a memory device (1) are provided. The method includes forming (11, 21) shallow trench isolation structures (400) in a substrate (100), where first trenches (B) are defined between adjacent protruding portions of the shallow trench isolation structures (400); forming (12, 22) floating gates (500) in first trenches (B) and performing a first etching on a part of the protruding portions to form second trenches (C) between the adjacent floating gates (500); performing (13, 23) a narrowing process on the floating gates (500); performing (14, 24) a second etching on a remaining part of the protruding portions to widen the second trenches (C); and forming (15, 26) a control gate (600) partially filled in the second trenches (C).

FIG. 14

EP 4 766 067 A2

## Description

## TECHNICAL FIELD

The present disclosure relates to the field of semiconductor technology, and in particular to a method for manufacturing a semiconductor device, a semiconductor device, and a memory device.

## BACKGROUND

With the development of semiconductor processes, the dimensions of devices become increasingly smaller, and the manufacturing difficulty increases correspondingly.

For semiconductor devices based on a floating gate structure, the filling of a control gate requires complete filling of gaps between floating gates. However, during the manufacturing process of semiconductor devices, the filling between floating gates is often incomplete (a void may occur), which may cause device reliability issues.

## SUMMARY OF THE DISCLOSURE

A technical problem addressed by some embodiments of the present disclosure is to provide a method for manufacturing a semiconductor device, a semiconductor device, and a memory device, which may reduce a void generated in a control gate during the filling process and improve the yield of the manufactured semiconductor device.

To address the above technical problem, a technical solution adopted by the present disclosure may provide a method for manufacturing a semiconductor device. The method may include: forming shallow trench isolation structures in a substrate, where each shallow trench isolation structure has a protruding portion protruding from a surface of the substrate and first trenches are defined between the adjacent protruding portions of the shallow trench isolation structures; forming floating gates in the first trenches and performing a first etching on a part of the protruding portions of the shallow trench isolation structures, where second trenches are formed between the adjacent floating gates; performing a narrowing process on the floating gates; performing a second etching on a remaining part of the protruding portions of the shallow trench isolation structures to widen the second trenches; and forming a control gate, where the control gate is partially filled in the second trenches.

In some embodiments, before forming the control gate, the method may further include: etching a dielectric layer on the floating gates.

In some embodiments, before forming the control gate, the method may further include: growing a dielectric layer on the floating gates.

In some embodiments, the dielectric layer may further include a first oxide layer, a first nitride layer, and a second oxide layer. The growing a dielectric layer on the floating gates may include: growing the first oxide layer on the floating gates; growing the first nitride layer on the first oxide layer; and growing the second oxide layer on the first nitride layer.

In some embodiments, a part of the dielectric layer may be disposed on sidewalls of the floating gates, forming sidewalls of the second trenches.

In some embodiments, the forming floating gates in first trenches may include: forming a polysilicon layer in the first trenches; and etching the polysilicon layer to form the floating gates, wherein an upper surface of the floating gates is higher than or flush with an upper surface of the shallow trench isolation structures.

In some embodiments, sidewalls of the second trench may be formed by opposing sidewalls between the adjacent floating gates. Each of the floating gates may include a first sidewall and a second sidewall. The first sidewall may be connected to a bottom of the second trench. The second sidewall may be connected to the first sidewall. An included angle between the first sidewall and the bottom of the second trench may be less than or equal to 90 degrees. An included angle between the second sidewall and the bottom of the second trench may be greater than 90 degrees.

In some embodiments, a cross-sectional area of the control gate located at a bottom of the second trenches may be smaller than a cross-sectional area of the control gate located at an opening of the second trenches.

To address the above technical problem, another technical solution adopted by the present disclosure may provide a semiconductor device. The semiconductor device may include a substrate, an oxide layer disposed on the substrate, shallow trench isolation structures, floating gates disposed on the oxide layer at intervals, and a control gate. Trenches may be defined between the adjacent floating gates. Each of the floating gates may include a first sidewall and a second sidewall connected to an end of the first sidewall away from the substrate. An opening of each of the trenches may gradually enlarge starting from the second sidewall in a direction away from the substrate. The control gate may be disposed in the trenches between the floating gates.

Another technical solution adopted by the present disclosure may provide a memory device. The memory device may include a semiconductor device, a configuration circuit, and a wiring. The semiconductor device may be the semiconductor device mentioned above or may be a semiconductor device obtained through the manufacturing method mentioned above.

Some technical effects of the present disclosure may be as follows. Different from the related art, some embodiments of the present disclosure may provide a method for manufacturing a semiconductor device, a semiconductor device, and a memory device. During a manufacturing process of a semiconductor device, in a case where the floating gates are manufactured but a filling of a control gate has not yet been started, only a part of protruding portions of shallow trench isolation structures may be etched to partially expose the floating gates. Then, a narrowing process may be performed on the floating gates so that an entire opening of the second trenches may be enlarged. Subsequently, after further etching the protruding portions of the shallow trench isolation structures, a void depth of each second trench may be reduced and an aspect ratio may be lowered. In this way, the filling of the control gate may become easier, which further reduces voids generated during the filling process of the control gate, thereby improving the yield of the manufactured semiconductor device.

## BRIEF DESCRIPTION OF THE DRAWINGS

In order to more clearly illustrate the technical solutions in some embodiments of the present disclosure, a brief introduction will be given below to the drawings required in the description of the embodiments. It is evident that the drawings described below are merely some embodiments of the present disclosure, and those skills in the art may obtain other drawings based on the following drawings without creative work.

FIG. 1 is a flowchart of an embodiment of a method for manufacturing a semiconductor device according to the present disclosure.
FIG. 2 is a schematic structural view illustrating a process corresponding to the method for manufacturing the semiconductor device in FIG. 1.
FIG. 3 is another schematic structural view illustrating the process corresponding to the method for manufacturing the semiconductor device in FIG. 1.
FIG. 4 is still another schematic structural view illustrating the process corresponding to the method for manufacturing the semiconductor device in FIG. 1.
FIG. 5 is still another schematic structural view illustrating the process corresponding to the method for manufacturing the semiconductor device in FIG. 1.
FIG. 6 is still another schematic structural view illustrating the process corresponding to the method for manufacturing the semiconductor device in FIG. 1.
FIG. 7 is still another schematic structural view illustrating the process corresponding to the method for manufacturing the semiconductor device in FIG. 1.
FIG. 8 is still another schematic structural view illustrating the process corresponding to the method for manufacturing the semiconductor device in FIG. 1.
FIG. 9 is still another schematic structural view illustrating the process corresponding to the method for manufacturing the semiconductor device in FIG. 1.
FIG. 10 is still another schematic structural view illustrating the process corresponding to the method for manufacturing the semiconductor device in FIG. 1.

FIG. 11 is a partial enlarged view of a second trench C shown in FIG. 9.
FIG. 12 is a flowchart of another embodiment of the method for manufacturing a semiconductor device according to the present disclosure.
FIG. 13 is a schematic structural view illustrating another process corresponding to the method for manufacturing a semiconductor device according to present disclosure.
FIG. 14 is another schematic structural view illustrating the another process corresponding to the method for manufacturing a semiconductor device according to present disclosure.
FIG. 15 is a schematic circuit view of the semiconductor device.
FIG. 16 is a schematic structural view of a dielectric layer according to some embodiments of the present disclosure.

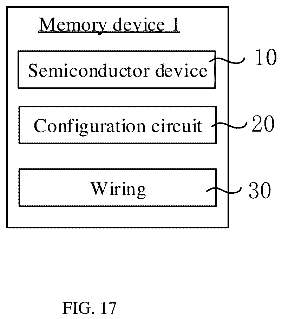

FIG. 17 is a schematic structural view of a memory device according to some embodiments of the present disclosure.

## DETAILED DESCRIPTION

The technical solutions in some embodiments of the present disclosure may be described clearly and completely below with reference to the accompanying drawings in the embodiments of the present disclosure. Obviously, the described embodiments are only a part of the embodiments of the present disclosure, not all of them. Based on the embodiments of the present disclosure, all other embodiments obtained by those skills in the art without creative effort shall fall within the scope of protection of the present disclosure.

It is worth noting that directional terms such as "upper," "lower," and "side" may be used herein to describe the interlayer structure of the semiconductor, based on the condition that a deposition plane of the semiconductor structure is located in a horizontal plane. The corresponding "height" and "depth" are described based on a vertical direction. The corresponding "width" is described based on a horizontal direction. In a case where an overall position of the semiconductor structure changes (e.g., rotation), the corresponding directional descriptions may vary, but structural characteristics identical to those in the present disclosure should also fall within the scope of protection of the present disclosure.

Furthermore, it is to be understood that the use of the term "substantially" herein, unless otherwise defined with respect to a specific context, with respect to a numeric quantity or otherwise quantifiable relationship, e.g., perpendicularity or parallelism, is to be understood as indicating that quantity +-10%. Thus, for example, lines that are substantially perpendicular to one another may be at angles between 81° and 99° to one another. In a further example, dimensions that are substantially between 1 mm and 3 mm, for example, may range from 0.9 mm to 3.3 mm. In another example, an angle that is substantially in the range of 1 to 1.1 radians may be between 0.9 radians and 1.21 radians.

With the development of semiconductor processes, the dimensions of devices become increasingly smaller, and the manufacturing difficulty increases correspondingly.

For semiconductor devices based on a floating gate structure, the filling of a control gate requires complete filling of gaps between floating gates. However, during the manufacturing process of semiconductor devices, the filling between floating gates is often incomplete (a void may occur), which may cause device reliability issues.

In view of the above, according to some embodiments of the present disclosure, during a manufacturing process of a semiconductor device, in a case where the floating gates are manufactured but a filling of a control gate has not yet been started, only a part of protruding portions of shallow trench isolation structures may be etched to partially expose the floating gates. Then, a narrowing process may be performed on the floating gates so that an entire opening of the second trenches may be enlarged. Subsequently, after further etching the protruding portions of the shallow trench isolation structures, a void depth of each second trench may be reduced and an aspect ratio may be lowered. In this way, the filling of the control gate may become easier, which further reduces voids generated during the filling process of the control gate, thereby improving the yield of the manufactured semiconductor device.

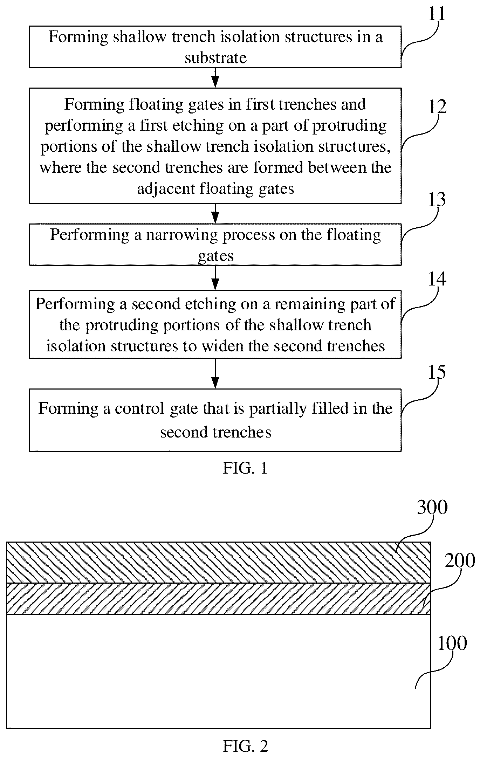

As shown in FIG. 1, FIG. 1 is a flowchart of an embodiment of a method for manufacturing a semiconductor device according to the present disclosure. The method may include the following operations.

At operation 11: forming shallow trench isolation structures in a substrate.

In some embodiments, the substrate may be made of a semiconductor material, such as a silicon substrate, a germanium substrate, a silicon-germanium substrate, or a group III-V compound substrate. It may be understood that the substrate is generally of a plate-like structure. An area of the substrate may be determined according to an area of a memory array to be manufactured. Typically, multiple sub-memory arrays may be formed from one substrate through a dicing process. Each sub-memory array may be further processed to form a memory chip.

An oxide layer 200 and a silicon nitride layer 300 may be sequentially formed on the substrate 100, as shown in FIG. 2.

In some embodiments, the oxide layer 200 may be an oxide of silicon, such as silicon dioxide.

The formation of the oxide layer 200 or the silicon nitride layer 300 on the substrate 100 may be performed by using physical vapor deposition (PVD) or chemical vapor deposition (CVD). The PVD refers to a process in which, under a vacuum condition, a surface of material source (solid or liquid) may be vaporized into gaseous atoms or molecules, or partially ionized into ions, and deposited onto a surface of the substrate through a low-pressure gas (or plasma) process to form a thin film with a specific function. The PVD coating technology may mainly include three types: vacuum evaporation coating, vacuum sputtering coating, and vacuum ion plating. The CVD refers to a method in which chemical gases or vapors may react on the surface of the substrate to synthesize a coating or a nanomaterial, which is one of the most widely used techniques in the semiconductor industry for depositing various materials, including a wide range of insulating materials, most metallic materials, and metallic alloy materials.

Taking the CVD as an example, two or more gaseous raw materials may be introduced into a reaction chamber, where they may chemically react with each other to form a new material that may be deposited on the surface of the substrate. The deposition of silicon nitride ($Si_3N_4$) may be one example, which may be formed by the reaction of silane and nitrogen.

In some embodiments, a deposition thickness of the oxide layer may be 50A to 200A and a deposition thickness of the nitride layer may be 500A to 2000A.

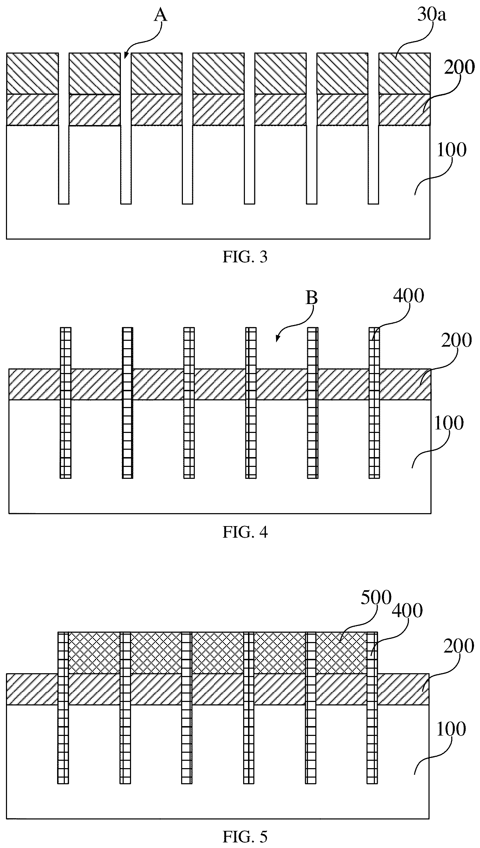

Using a hard mask layer as a mask, a plurality of shallow trenches A may be formed or defined in the substrate 100. The silicon nitride layer 300 may form a silicon nitride structure 30a, as shown in FIG. 3.

The formation of trenches in a material may generally be performed through an etching process. Etching is an important operation in a semiconductor manufacturing process, a microelectronics integrated circuit (IC) manufacturing process, and a micro/nano manufacturing process. The etching may first involve photolithographically exposing and developing a photoresist, followed by selectively removing unwanted portions through chemical or physical processes. The etching may be a process in which unwanted materials are selectively removed from a surface of a silicon wafer by chemical or physical means, with a basic objective of accurately replicating a mask pattern on the coated silicon wafer.

The shallow trench isolation structures 400 may then be formed in the plurality of shallow trenches A. The silicon nitride structure 30a may be further removed to form first trenches B, as shown in FIG. 4. That is, each shallow trench isolation structure 400 may have a protruding portion protruding from the surface of the substrate 100. The first trenches B may be defined between the adjacent protruding portions of the shallow trench isolation structures 400.

At operation 12: forming floating gates in first trenches and performing a first etching on a part of protruding portions of the shallow trench isolation structures. The second trenches may be formed between adjacent floating gates.

The floating gates 500 may be formed in the first trenches B, as shown in FIG. 5.

In some embodiments, a polysilicon layer may be formed in the first trenches B. The polysilicon layer may be etched to form the floating gates 500. An upper surface of the floating gates 500 may be higher than or flush with an upper surface of the shallow trench isolation structures 400.

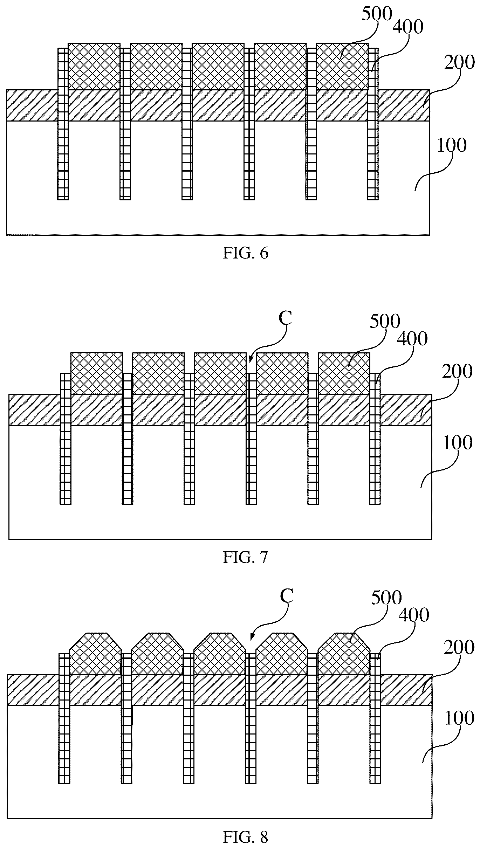

In some other embodiments, the floating gates 500 may be formed in the first trenches B, as shown in FIG. 6.

In some embodiments, the polysilicon layer may be formed in the first trenches B. The polysilicon layer may be etched to form the floating gates 500. The upper surface of the floating gates 500 may be higher than the upper surface of the shallow trench isolation structures 400.

In some embodiments, there may be multiple methods for forming the polysilicon layer in the first trenches B, such as using a mask and a deposition process, or by combining deposition, chemical mechanical polishing (CMP), and blanket etching processes.

A polysilicon may be a crystalline form of silicon. In a case where molten silicon solidifies under a supercooled condition, silicon atoms may form numerous crystal nuclei in a diamond lattice arrangement. In a case where the crystal nuclei grow into grains with different crystal orientations, the grains after combing with each other may crystalize into the polysilicon.

In some other embodiments, a mask may be adopted to deposit the polysilicon in the first trenches B. In this case, an upper surface of the polysilicon may not be lower than the upper surface of the shallow trench isolation structures 400, with the depth not being limited. The polysilicon layer may then be etched to form the floating gates 500. The upper surface of the polysilicon may be higher than or flush with the upper surface of the shallow trench isolation structures 400. The above operation may be implemented through photolithography.

As shown in FIG. 7, in a case where the floating gates 500 are formed in the first trenches B, the first etching may be performed on a part of the protruding portions of the shallow trench isolation structures 400. Second trenches C may be formed or defined between the adjacent floating gates 500. That is, the floating gates 500 may be partially exposed.

At operation 13: performing a narrowing process on the floating gates.

As shown in FIG. 8, in a case where the second trenches C are formed between the adjacent floating gates 500, i.e., after the floating gates 500 are exposed, the narrowing process may be performed on the floating gates 500. Since the floating gates 500 may have a three-dimensional structure, side edges of the floating gates 500 may be etched so that each floating gate may have a substantially trapezoidal shape. That is, after the narrowing process of the floating gates 500, a distance between the adjacent floating gates may increase. That is, an opening of each second trench C may be enlarged.

At operation 14: performing a second etching on a remaining part of the protruding portions of the shallow trench isolation structures to widen the second trenches.

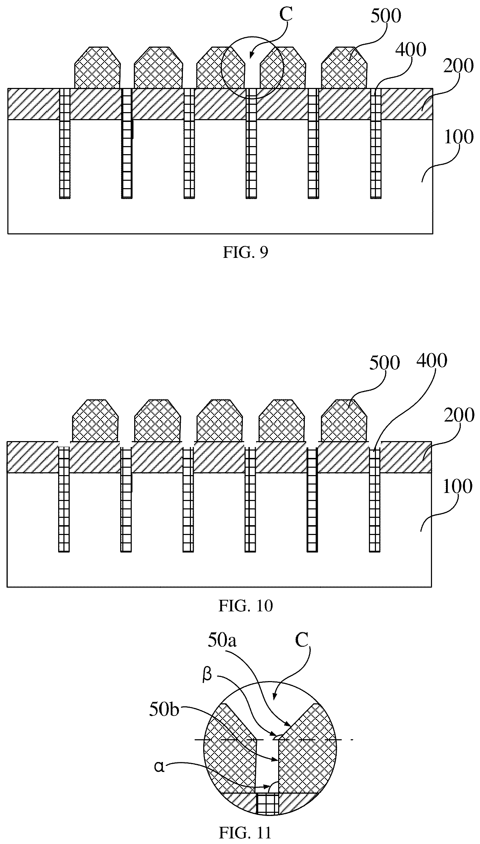

As shown in FIG. 9, after performing the narrowing process on the floating gates 500, the second etching may be further performed on the remaining part of the protruding portions of the shallow trench isolation structures 400 to widen the second trenches C. In addition, the second trenches C may further be deepened.

During the etching process, the second trenches C may not only be deepened but may further cause a certain degree of damage to side portions of the floating gates 500, thereby serving to widen the second trenches C and making gaps between the floating gates 500 broader.

In some embodiments, as shown in FIG. 10, the second etching of the remaining part of the protruding portions of the shallow trench isolation structures may be performed such that the upper surface of the shallow trench isolation structures 400 after etching may be flush with or lower than an upper surface of the oxide layer 200.

In some embodiments, as shown in FIG. 11, sidewalls of second trenches C may be formed by opposing sidewalls between the adjacent floating gates 500. Each floating gate may include a first sidewall 50b and a second sidewall 50a. The first sidewall 50b may be connected to a bottom of the second trench C. The second sidewall 50a may be connected to the first sidewall 50b. An included angle $\alpha$ between the first sidewall 50b and the bottom of the second trench C may be less than or equal to 90 degrees. An included angle $\beta$ between the second sidewall 50a and the bottom of the second trench C may be greater than 90 degrees. That is, the opening of the second trench C may gradually enlarge starting from the second sidewall 50a.

At operation 15: forming a control gate. The control gate may be partially filled in the second trenches.

The control gate 600 may be formed. A part of the control gate 600 may be filled in the second trenches C. In this case, a cross-sectional area of the control gate 600 located at the bottom of the second trenches C may be smaller than a cross-sectional area of the control gate 600 located at the opening of the second trenches C.

During the manufacturing process of the semiconductor device, in a case where the floating gates 500 have been formed but the filling of the control gate 600 has not been started yet, i.e., after the floating gates 500 have been formed and before the filling of the control gate 600 is started, the protruding portions of the shallow trench isolation structures 400 may be only partially etched to expose a part of the floating gates 500. The narrowing process may be performed on the floating gates 500 so that an entire opening of the second trenches C may be enlarged. Subsequently, after further etching the protruding portions of the shallow trench isolation structures 400, a void depth of each second trench C may be reduced and an aspect ratio may be lowered. In this way, the filling of the control gate 600 may become easier, which further reduces voids generated during the filling process of the control gate 600, thereby improving the yield of the manufactured semiconductor device.

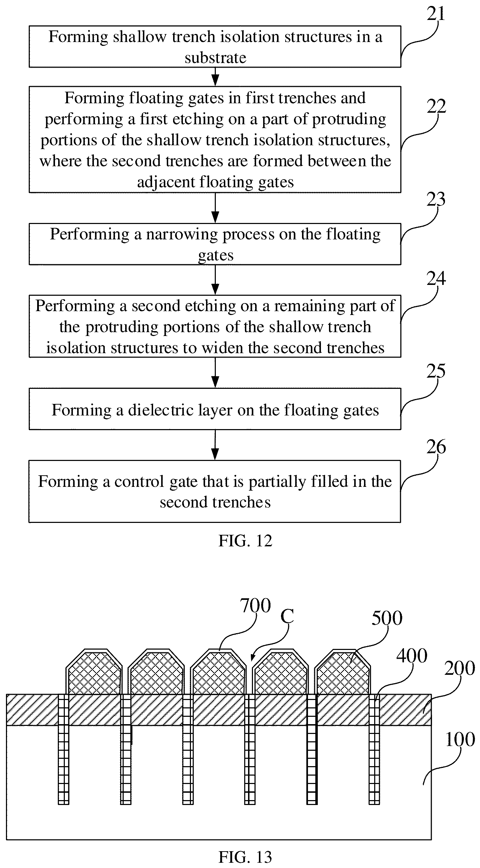

As shown in FIG. 12, FIG. 12 is a flowchart of another embodiment of the method for manufacturing a semiconductor device according to the present disclosure. The method may include the following operations.

At operation 21: forming shallow trench isolation structures in a substrate.

At operation 22: forming floating gates in first trenches and performing a first etching on a part of protruding portions of the shallow trench isolation structures. The second trenches may be formed between the adjacent floating gates.

At operation 23: performing a narrowing process on the floating gates.

At operation 24: performing a second etching on a remaining part of the protruding portions of the shallow trench isolation structures to widen the second trenches.

The schematic manufacturing views corresponding to operations 21-24 may refer to FIGS. 2-9, which will not be repeated herein.

At operation 25: forming a dielectric layer on the floating gates.

As shown in FIG. 12, a dielectric layer 700 may be formed on the floating gates 500.

In some embodiments, the dielectric layer 700 may be an oxide layer, a nitride layer, or a stacked layer thereof. For example, the stacked layer may be formed by stacking the oxide layer and a mixed layer, which is formed by an oxide and a nitride, together

In some embodiments, the dielectric layer 700 may be etched on the floating gates 500. For example, a first oxide layer 701 may be formed on the floating gates 500. A first nitride layer 702 may be formed on the first oxide layer 701. A second oxide layer 703 may be formed on the first nitride layer 702.

In some embodiments, the dielectric layer 700 may be grown on the floating gates 500. For example, a first oxide layer 701 may be grown on the floating gates 500. A first nitride layer 702 may be grown on the first oxide layer 701. A second oxide layer 703 may be grown on the first nitride layer 702. That is, the dielectric layer 700 may include the first oxide layer 701, the first nitride layer 702, and the second oxide layer 703. The first oxide layer 701, the first nitride layer 702, and the second oxide layer 703 may be sequentially stacked on the floating gates 500. The first oxide layer 701 may be disposed in contact with or attached to the floating gates 500.

In a case where the dielectric layer 700 is formed on the floating gates 500, a part of the dielectric layer 700 may be disposed on the sidewalls of the floating gates, thereby forming the sidewalls of the second trenches C.

In some embodiments, the sidewalls of the second trenches C may be defined or formed by the dielectric layer 700 on opposing sidewalls between the adjacent floating gates 500. A shape of the dielectric layer 700 may be substantially consistent with shapes of the sidewalls of the floating gates 500. A part of the dielectric layer 700 may be disposed in contact with the sidewalls of the floating gates 500.

At operation 26: forming a control gate. The control gate may be partially filled in the second trenches.

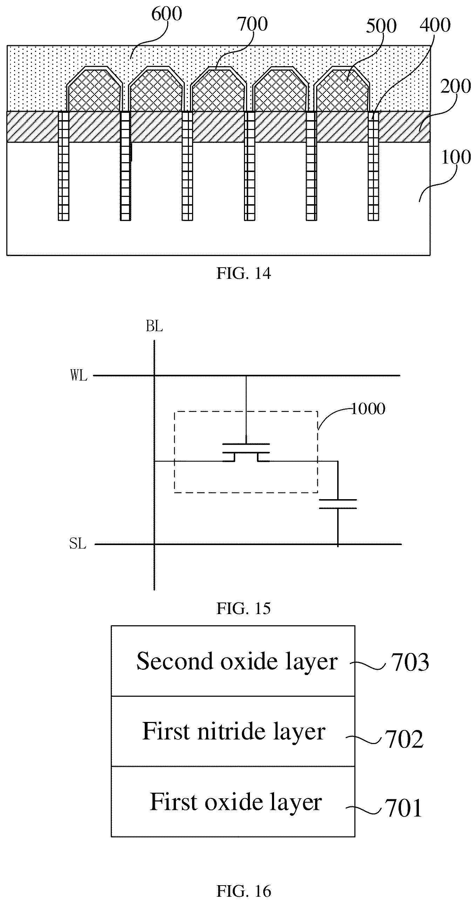

As shown in FIG. 14, the control gate 600 may be formed. A part of the control gate 600 may be filled in the second trenches C. In this case, a cross-sectional area of the control gate 600 located at the bottom of each second trench C may be smaller than a cross-sectional area of the control gate 600 located at the opening of each second trench C.

In the present embodiments, during the manufacturing process of the semiconductor device, in a case where the floating gates 500 have been formed but the filling of the control gate 600 has not been started yet, the protruding portions of the shallow trench isolation structures 400 may be only partially etched to expose a part of the floating gates 500. The narrowing process may be performed on the floating gates 500 so that an entire opening of the second trenches C may be enlarged. Subsequently, after further etching the protruding portions of the shallow trench isolation structures 400, a void depth of each second trench C may be reduced and an aspect ratio may be lowered. In this way, the filling of the control gate 600 may become easier, which further reduces voids generated during the filling process of the control gate 600, thereby improving the yield of the manufactured semiconductor device.

Furthermore, taking FIG. 14 as an example, the structure of the semiconductor device is described as follows.

The semiconductor device may include the substrate 100, the oxide layer 200, the shallow trench isolation structures 400, the floating gates 500, the dielectric layer 700, and the control gate 600.

In some embodiments, the oxide layer 200 may be disposed on the substrate 100. The floating gates 500 may be disposed on the oxide layer 200.

The dielectric layer 700 may be formed on surfaces (an upper surface and sidewalls) of the floating gates 500. The control gate 600 may be formed in the trenches between the floating gates 500 and on the dielectric layer 700.

In some embodiments, the substrate 100 may be made of a semiconductor material, such as silicon, germanium, or silicon-germanium. The oxide layer 200 may be an oxide of silicon, such as silicon oxide. In a memory structure based on NOR FLASH, the oxide layer 200 may be referred to as an erase through oxide (ETOX) layer. The floating gates 500 and the control gate 600 may be polysilicon. The dielectric layer 700 may be an oxide layer, a nitride layer, or a stacked layer thereof. For example, the stacked layer may be formed by stacking the oxide layer and a mixed layer, which is formed by an oxide and a nitride, together.

In some embodiments, the semiconductor device may further include a source and drain region (not shown in the figures). The source and drain region may be a conductive region formed in the substrate 100 by particle implantation/doping and led out through connected metal wires. It may be understood that the above-mentioned materials are merely examples, and similar materials may be used in other embodiments, which will not be described in detail herein.

The control gate 600 in the above semiconductor device may correspond to a gate of an ordinary transistor, with a difference in that the floating gates 500 are additionally provided. The floating gates 500 may have no electrical connection with the outside and may be surrounded and wrapped by the oxide layer 200 and the dielectric layer 700, which may be considered electrically floating and thus referred to as the floating gate. The floating gates may be configured to capture and store electrons. Since there is no external circuit, the electrons may not be lost even after power-off. The amount of electrons stored in the floating gate structure may change a threshold voltage, i.e., Vth, of the field effect transistor. Different Vth values may represent different states, thereby realizing information storage.

Next, referring to FIG. 15, FIG. 15 is a schematic circuit view of the semiconductor device. The above-described semiconductor device may correspond to a field-effect transistor 1000 in FIG. 15. A gate of the transistor may correspond to the control gate 600 in FIG. 14 and may be connected to a write line (WL). A drain of the transistor may correspond to the drain in the source and drain region (not shown in the figures) of the semiconductor device and may be connected to a bit line (BL). The source of the transistor may correspond to the source in the source and drain region of the semiconductor device. The source may form a memory capacitor with a common source line (SL) in the semiconductor device.

The above semiconductor device may be considered as a memory cell. Each memory cell may include one access switch (i.e., a transistor) and one memory capacitor. The memory capacitor may represent logical "1" or "0" according to the amount of charge stored therein, or in other words, according to a voltage difference between two terminals of the memory capacitor being high or low. The conduction and cutoff of the access switch may determine whether the information stored in the memory capacitor is allowed or prohibited to be read or rewritten.

In some embodiments, the word line WL may determine whether the access switch is conducted or cutoff. The bit line BL may be the only channel through which the outside accesses the memory capacitor. In a case where the access switch is conducted or turned on, external operations such as reading or writing of the memory capacitor may be performed through the bit line BL.

In some embodiments, a common terminal (Common) of the memory capacitor may be connected to a common source line (having a voltage of Vref).

In a case where the information stored in the memory capacitor represents "1," a voltage at the other terminal of the memory capacitor may be 2Vref. In this case, the stored charge may be:

$$Q=+Vref*C.$$

In a case where the information stored in the memory capacitor represents "0," a voltage at the other terminal of the memory capacitor may be 0. In this case, the stored charge may be:

$$Q=-Vref*C.$$

In some other embodiments, in a case where the semiconductor memory device shown in FIG. 14 is formed, a protective layer and/or an insulating layer may be covered on the semiconductor device. Wirings may be arranged in the protective layer and/or the insulating layer.

Furthermore, some embodiments of the present disclosure may further provide a memory device 1, which may include a semiconductor device 10. The semiconductor device 10 may be the semiconductor device described above or a semiconductor device obtained through the manufacturing method described above.

In addition, the memory device 1 may be a memory device including a flash memory (FLASH), for example, a NOR FLASH.

In some embodiments, the memory device 1 may further include a main control chip and a memory chip. The memory chip may include a memory array and a corresponding configuration circuit 20 and a corresponding wiring 30. The memory array may be the semiconductor device provided in the above embodiments or a semiconductor device obtained through the manufacturing method provided in any one of the above embodiments. The semiconductor device 10 may be connected to the corresponding configuration circuit 20 through the corresponding wiring 30.

The embodiments of the present disclosure may be implemented in the form of software functional units and may be sold or used as independent products. The software functional units may be stored in a computer-readable storage medium. Based on this understanding, the technical solutions of the present disclosure, or the parts thereof that essentially contribute to the prior art, may be embodied as a software product. The computer software product may be stored in a storage medium and may include several instructions for enabling a computer device (which may be a personal computer, a server, or a network device, etc.) or a processor to execute all or part of the operations of the methods described in the embodiments of the present disclosure. The aforementioned storage medium may include various media capable of storing program codes, such as a USB flash drive, a mobile hard disk, a read-only memory (ROM), a random-access memory (RAM), a magnetic disk, or an optical disk.

The foregoing description is merely exemplary embodiments of the present disclosure and is not intended to limit the scope of the present disclosure. Any equivalent structural or process transformations made based on the content of the specification and drawings of the present disclosure, or any direct or indirect applications to other related technical fields, shall be included within the protection scope of the present disclosure.

**Claims**

1. A method for manufacturing a semiconductor device (10), **characterized by** comprising:

   forming (11, 21) shallow trench isolation structures (400) in a substrate (100), wherein each shallow trench isolation structure (400) has a protruding portion protruding from a surface of the substrate (100) and first trenches (B) are defined between the adjacent protruding portions of the shallow trench isolation structures (400);
   forming (12, 22) floating gates (500) in the first trenches (B) and performing a first etching on a part of the protruding portions of the shallow trench isolation structures (400), wherein second trenches (C) are formed between the adjacent floating gates (500);
   performing (13, 23) a narrowing process on the floating gates (500);
   performing (14, 24) a second etching on a remaining part of the protruding portions of the shallow trench isolation structures (400) to widen the second trenches (C); and
   forming (15, 26) a control gate (600), wherein the control gate (600) is partially filled in the second trenches (C).

2. The method as claimed in claim 1, wherein before forming (26) the control gate (600), the method further comprises:
   etching a dielectric layer (700) on the floating gates (500).

3. The method as claimed in claim 1, wherein before (26) forming the control gate (600), the method further comprises:
   growing a dielectric layer (700) on the floating gates (500).

4. The method as claimed in claim 3, wherein the dielectric layer (700) comprises a first oxide layer (701), a first nitride layer (702), and a second oxide layer (703); and

wherein the growing a dielectric layer (700) on the floating gates (500), comprises:

   growing the first oxide layer (701) on the floating gates (500);
   growing the first nitride layer (702) on the first oxide layer (701); and
   growing the second oxide layer (703) on the first nitride layer (702).

5. The method as claimed in claim 3, wherein a part of the dielectric layer (700) is disposed on sidewalls of the floating gates (500), forming sidewalls of the second trenches (C).

6. The method as claimed in claim 1, wherein the forming (12, 22) floating gates (500) in first trenches (B), comprises:

   forming a polysilicon layer in the first trenches (B); and
   etching the polysilicon layer to form the floating gates (500), wherein an upper surface of the floating gates (500) is higher than or flush with an upper surface of the shallow trench isolation structures (400).

7. The method as claimed in claim 1, wherein sidewalls of the second trench (C) are formed by opposing sidewalls between the adjacent floating gates (500), each of the floating gates (500) comprises a first sidewall (50b) and a second sidewall (50a), the first sidewall (50b) is connected to a bottom of the second trench (C), and the second sidewall (50a) is connected to the first sidewall (50b);
   an included angle ($\alpha$) between the first sidewall (50b) and the bottom of the second trench (C) is less than or equal to 90 degrees and an included angle ($\beta$) between the second sidewall (50a) and the bottom of the second trench (C) is greater than 90 degrees.

8. The method as claimed in claim 1, wherein a cross-sectional area of the control gate (600) located at a bottom of the second trenches (C) is smaller than a cross-sectional area of the control gate (600) located at an opening of the second trenches (C).

9. The method as claimed in claim 1, wherein the performing (14, 24) a narrowing process on the floating gates (500), comprises:
   etching side edges of the floating gates (500) to enable each of the floating gates (500) to have a substantially trapezoidal shape.

10. A semiconductor device (10), **characterized by** comprising:

   a substrate (100);

an oxide layer (200), disposed on the substrate (100);

shallow trench isolation structures (400);

floating gates (500), disposed on the oxide layer (200) at intervals, wherein trenches (C) are defined between the adjacent floating gates (500), each of the floating gates (500) comprises a first sidewall (50b) and a second sidewall (50a) connected to an end of the first sidewall (50b) away from the substrate (100), and an opening of each of the trenches (C) continuously widens from a connection of the first sidewall (50b) and the second sidewall (50a) in a direction away from the substrate (100); and

a control gate (600), disposed in the trenches (C) between the floating gates (500).

11. The semiconductor device as claimed in claim 10, wherein a dielectric layer (700) is disposed on the floating gates (500).

12. The semiconductor device as claimed in claim 11, wherein the dielectric layer (700) comprises a first oxide layer (701), a first nitride layer (702), and a second oxide layer (703);

the first oxide layer (701) is disposed on the floating gates (500), the first nitride layer (702) is disposed on the first oxide layer (701), and the second oxide layer (703) is disposed on the first nitride layer (702).

13. The semiconductor device as claimed in claim 10, wherein for each of the floating gates (500), the first sidewall (50b) is connected to a bottom of the corresponding trench (C), the second sidewall (50a) is connected to the first sidewall (50b), an included angle ($\alpha$) between the first sidewall (50b) and the bottom of the trench (C) is less than or equal to 90 degrees, and an included angle ($\beta$) between the second sidewall (50a) and the bottom of the trench (C) is greater than 90 degrees.

14. The semiconductor device as claimed in claim 10, wherein a cross-sectional area of the control gate (600) located at a bottom of the second trenches (C) is smaller than a cross-sectional area of the control gate (600) located at an opening of the second trenches (C).

15. A memory device (1), **characterized by** comprising:

a semiconductor device (10) as claimed in any one of claims 10-14 or obtained through the method as claimed in any one of claims 1-9;

a configuration circuit (20); and

a wiring (30).

```
┌─────────────────────────────────────────────┐  11
│  Forming shallow trench isolation structures │
│                 in a substrate               │
└─────────────────────────────────────────────┘
                      │
                      ▼
┌─────────────────────────────────────────────┐  12
│  Forming floating gates in first trenches    │
│  and performing a first etching on a part of │
│  protruding portions of the shallow trench   │
│  isolation structures, where the second      │
│  trenches are formed between the adjacent    │
│  floating gates                              │
└─────────────────────────────────────────────┘
                      │
                      ▼
┌─────────────────────────────────────────────┐  13
│  Performing a narrowing process on the       │
│  floating gates                              │
└─────────────────────────────────────────────┘
                      │
                      ▼
┌─────────────────────────────────────────────┐  14
│  Performing a second etching on a remaining  │
│  part of the protruding portions of the      │
│  shallow trench isolation structures to      │
│  widen the second trenches                   │
└─────────────────────────────────────────────┘
                      │
                      ▼
┌─────────────────────────────────────────────┐  15
│  Forming a control gate that is partially    │
│  filled in the second trenches               │
└─────────────────────────────────────────────┘
```

FIG. 1

FIG. 2

A

30a

200

100

FIG. 3

B

400

200

100

FIG. 4

500 400

200

100

FIG. 5

FIG. 6

FIG. 7

FIG. 8

FIG. 9

FIG. 10

FIG. 11

Forming shallow trench isolation structures in a substrate — 21

Forming floating gates in first trenches and performing a first etching on a part of protruding portions of the shallow trench isolation structures, where the second trenches are formed between the adjacent floating gates — 22

Performing a narrowing process on the floating gates — 23

Performing a second etching on a remaining part of the protruding portions of the shallow trench isolation structures to widen the second trenches — 24

Forming a dielectric layer on the floating gates — 25

Forming a control gate that is partially filled in the second trenches — 26

FIG. 12

FIG. 13

600 700 500 400

200

100

FIG. 14

BL

WL

1000

SL

FIG. 15

| Second oxide layer | 703 |
| First nitride layer | 702 |
| First oxide layer | 701 |

FIG. 16

Memory device 1

| Semiconductor device | 10 |
| Configuration circuit | 20 |
| Wiring | 30 |

FIG. 17